# EUROPÄISCHE PATENTSCHRIFT

(11) **EP 2 791 626 B1**
(45) Veröffentlichungstag und Bekanntmachung des Hinweises auf die Patenterteilung: **13.07.2016**
(21) Anmeldenummer: 12798218.9
(22) Anmeldetag: 22.11.2012
(51) Int. Cl.: G01D 11/26, G01D 11/24, H05K 7/14

(54) **GEHÄUSEDECKEL FÜR EIN ELEKTRONIK-GEHÄUSE BZW. DAMIT GEBILDETES ELEKTRONIK-GEHÄUSE**
HOUSING COVER FOR AN ELECTRONICS HOUSING AND ELECTRONICS HOUSING FORMED THEREWITH
COUVERCLE DE BOÎTIER POUR UN BOÎTIER ÉLECTRONIQUE ET BOÎTIER ÉLECTRONIQUE AINSI CONSTITUÉ

(30) Priorität: 14.12.2011 DE 102011088495
(43) Veröffentlichungstag der Anmeldung: 22.10.2014
(73) Patentinhaber: Endress+Hauser Flowtec AG, 4153 Reinach (BL) (CH)
(72) Erfinder: LOEFFEL, Philipp, CH-4104 Oberwil (CH); DETTE, Utz, 79539 Lörrach (DE); KAMBER, Sascha, CH-4147 Aesch (CH)
(74) Vertreter: Andres, Angelika Maria
(86) Internationale Anmeldenummer: PCT/EP2012/073326
(87) Internationale Veröffentlichungsnummer: WO 2013/087390

(56) Entgegenhaltungen:
- EP-A1- 0 829 004
- DE-A1-102008 025 202
- DE-A1-102009 030 494
- DE-U- 7 149 350
- DE-U1-202010 003 744
- US-A- 5 324 888

## Beschreibung

Die Erfindung betrifft einen Gehäusedeckel für ein Elektronik-Gehäuse sowie ein Elektronik-Gehäuse für ein, insb. als Meß- und/oder Schaltgerät der industriellen Meß- und Automatisierungstechnik ausgebildetes, elektronisches, Gerät.

In der industriellen Prozeß-Meßtechnik werden, insb. auch im Zusammenhang mit der Automation chemischer oder verfahrenstechnischer Prozesse und/oder der automatisierten Steuerung von industriellen Anlagen, prozeßnah installierte elektronische Meß- und/oder Schaltgeräte, so genannte Feldgeräte, wie z.B. Coriolis-Massendurchfluß-Meßgeräte, Dichte-Meßgeräte, magnetisch-induktive Durchflußmeßgeräte, Wirbel-Durchflußmeßgeräte, Ultraschall-Durchflußmeßgeräte, thermische Massendurchfluß-Meßgeräte, Druck-Meßgeräte, Füllstand-Meßgeräte, Temperatur-Meßgeräte, ph-Wert-Meßgeräte etc., eingesetzt, die der Erzeugung von Prozeßgrößen - analog oder digital - repräsentierenden Meßwerten sowie diese letztlich tragende Meßwertsignalen dienen. Bei den jeweils zu erfassenden Prozeßgrößen kann es sich je nach Anwendung beispielsweise, um einen Massendurchfluß, eine Dichte, eine Viskosität, einen Füll- oder einen Grenzstand, einen Druck oder eine Temperatur oder dergleichen, eines flüssigen, pulver-, dampf- oder gasförmigen Mediums handeln, das in einem entsprechenden Behälter, wie z.B. einer Rohrleitung oder einem Tank, geführt bzw. vorgehalten wird.

Zum Erfassen der jeweiligen Prozeßgrößen weisen elektronische Geräte der in Rede stehenden Art jeweils einen entsprechenden physikalisch-elektrischen oder chemisch-elektrischen Meßaufnehmer auf. Dieser ist zumeist in eine Wandung des das Medium jeweils führenden Behälters oder der in den Verlauf einer das Medium jeweils führenden Leitung, beispielsweise eine Rohrleitung, eingesetzt und dient dazu, wenigstens ein mit der zu erfassenden Prozeßgröße entsprechend korrespondierendes elektrisches Meßsignal zu erzeugen. Zum Verarbeiten des Meßsignals ist der Meßaufnehmer weiters mit einer in einer Gerät-Elektronik des Feldgeräts vorgesehenen, der Weiterverarbeitung oder Auswertung des wenigstens einen Meßsignals wie auch der Generierung entsprechender Meßwertesignale dienenden Meßgerät internen Betriebs- und Auswerteschaltung verbunden. Weiterführende Beispiele für derartige, dem Fachmann an und für sich bekannte Meßgeräte, insb. auch deren Verwendung und deren Betrieb betreffende Einzelheiten, sind u.a. in der DE-A 10 2005 025 670, der DE-A 10 2008 042972, der DE-A 101 26 654, der DE-U 297 04 361, der US-A 2004/0183550, der US-A 2006/0120054, der US-A 2006/0161359, der US-A 2009/0277278, der US-A 45 74 328, der US-A 48 50 213, der US-A 57 06 007, der US-B 62 36 322, der US-B 63 66 436, der US-B 65 39 819, der US-B 65 56 447, der US-B 78 75 797, der WO-A 02/103327, der WO-A 96/37764 oder der WO-A 98/14763 hinreichend ausführlich und detailliert beschrieben.

Bei einer Vielzahl von Feldgeräten wird der Meßaufnehmer zum Erzeugen des Meßsignals im Betrieb zudem von einem von der Betriebs- und Auswerteschaltung zumindest zeitweise generierten Treibersignal so angesteuert, daß er in einer für die Messung geeigneten Weise zumindest mittelbar oder aber auch über eine das Medium direkt kontaktierende Sonde praktisch unmittelbar auf das Medium einwirkt, um dort mit der zu erfassenden Meßgröße entsprechend korrespondierende Reaktionen hervorzurufen. Das Treibersignal kann dabei beispielsweise hinsichtlich einer Stromstärke, einer Spannungshöhe und/oder einer Frequenz entsprechend geregelt sein. Als Beispiele für solche aktiven, also ein elektrisches Treibersignal im Medium entsprechend umsetzende Meßaufnehmer sind im besonderen dem Messen von zumindest zeitweise strömenden Medien dienende Durchfluß-Meßaufnehmer, z.B. mit wenigstens einer vom Treibersignal angesteuerten, Magnetfeld erzeugenden Spule oder wenigstens einem vom Treibersignal angesteuerten Ultraschallsender, oder aber auch dem Messen und/oder Überwachen von Füllständen in einem Behälter dienende Füllstands- und/oder Grenzstandsaufnehmer, wie z.B. mit freistrahlender Mikrowellenantenne, Gouboun-Leitung oder vibrierendem Tauchkörper, zu nennen.

Bei elektronisch Geräten der in Rede stehenden Art kann die jeweilige - zumeist als Umformer-Elektronik, nämlich interne proprietäre Meßwertsignale in standardisierte externe Meßwertsignale bzw. -telegramme wandelnde Elektronik ausgebildete - Gerät-Elektronik üblicherweise über entsprechende elektrische Leitungen an ein vom jeweiligen Gerät zumeist räumlich entfernt angeordnetes und zumeist auch räumlich verteiltes übergeordneten elektronischen Datenverarbeitungssystem elektrisch angeschlossen werden, an das die vom jeweiligen Gerät erzeugten Meßwerte mittels eines diese entsprechend tragenden Meßwertesignals zeitnah weitergegeben werden. Zudem sind solche Geräte im Betrieb üblicherweise mittels eines innerhalb des übergeordneten Datenverarbeitungssystems vorgesehenen Datenübertragungsnetzwerks miteinander und/oder mit entsprechenden elektronischen Prozeß-Steuerungen verbunden, beispielsweise vor Ort installierte Speicherprogrammierbare Steuerungen oder in einer entfernten Leitwarte installierte Prozeß-Leitrechnern, wohin die mittels des Geräts gegebenenfalls erzeugten und in geeigneter Weise digitalisierten und entsprechend codierten Meßwerte weitergesendet werden. Mittels solcher Prozeß-Leitrechner können die übertragenen Meßwerte weiterverarbeitet und als entsprechende Meßergebnisse z.B. auf Monitoren visualisiert und/oder in Steuersignale für andere als Stellgeräte ausgebildete Feldgeräte, wie z.B. Magnet-Ventile, Elektro-Motoren etc., umgewandelt werden. Da moderne, mittels Geräten der in Rede stehenden Art gebildete Meßanordnungen zumeist auch direkt von solchen Leitrechnern aus überwacht und gegebenenfalls gesteuert und/oder konfiguriert werden können, werden in entsprechender Weise über vorgenannte, zumeist hinsichtlich der Übertragungsphysik und/oder der Übertragungslogik hybride Datenübertragungsnetzwerke dem jeweiligen Feldgerät zugewiesene Betriebsdaten gleichermaßen versendet. Dementsprechend dient das Datenverarbeitungssystem üblicherweise auch dazu, das vom Feldgerät gegebenenfalls gelieferte Meßwertesignal entsprechend den Anforderungen nachgelagerter Datenübertragungsnetzwerke zu konditionieren, beispielsweise geeignet zu digitalisieren und gegebenenfalls in ein entsprechendes Telegramm umzusetzen, und/oder vor Ort auszuwerten. Dafür sind in solchen Datenverarbeitungssystemen mit den jeweiligen Verbindungsleitungen elektrisch gekoppelte Auswerteschaltungen vorgesehen, die die vom jeweiligen, etwa als Meß- und/oder Schaltgerät ausgebildeten, elektronischen Gerät empfangenen Meßwerte vor- und/oder weiterverarbeiten sowie, falls erforderliche, geeignet konvertieren. Zur Datenübertragung dienen in solchen industriellen Datenverarbeitungssystemen zumindest abschnittsweise, insb. serielle, Feldbusse, wie z.B. FOUNDATION FIELDBUS, RACKBUS-RS 485, PROFIBUS etc., oder beispielsweise auch Netzwerke auf Basis des ETHERNET-Standards sowie die entsprechenden, zumeist übergreifend standardisierten Übertragungs-Protokolle. Neben den für die Verarbeitung und Konvertierung der von den jeweils angeschlossenen Feldgerät gelieferten Meßwerte erforderlichen Auswerteschaltungen weisen solche übergeordnete Datenverarbeitungssysteme zumeist auch der Versorgung der angeschlossenen Meß- und/oder Schaltgräte mit elektrischer Energie dienende elektrische Versorgungsschaltungen auf, die eine entsprechende, ggf. direkt vom angeschlossenen Feldbus gespeiste, Versorgungsspannung für die jeweilige Gerät-Elektronik bereitstellen und die daran angeschlossenen elektrische Leitungen sowie die jeweiligen Gerät-Elektroniken durchfließende elektrische Ströme treiben. Eine Versorgungsschaltung kann dabei beispielsweise genau einem Feldgerät jeweils zugeordnet und zusammen mit der dem jeweiligen Feldgerät zugeordneten Auswerteschaltung - beispielsweise zu einem entsprechenden Feldbusadapter vereint - in einem gemeinsamen, z.B. als Hutschienen-Modul lausgebildeten und/oder in einem Schaltschrank installierten, Elektronik-Gehäuse untergebracht sein.

Bei Geräten der in Rede stehenden Art, mithin Feldgeräten der industriellen Meß- und Automatisierungstechnik, ist die jeweilige Gerät-Elektronik zumeist in einem vergleichsweise robusten, etwa schlag-, druck-, explosions- und/oder wetterfesten, Elektronik-Gehäuse untergebracht. Dieses kann vom Gerät entfernt angeordnet und mit diesem nur über eine flexible Leitung verbunden sein; es kann aber auch, wie z.B. in der eingangs erwähnten oder der gezeigt, direkt am Meßaufnehmer oder einem den Meßaufnehmer separat einhausenden Meßaufnehmer-Gehäuse angeordnet sein. Beispiele für solche, für Feldgeräte geeignete Elektronik-Gehäuse sind u.a. in den eingangs erwähnten US-B 63 66 436, der DE-A 101 26 654, der DE-A 10 2008 042 972, der US-B 65 56 447 oder der WO-A 98/14763 beschrieben. Demnach umfassen solche Elektronik-Gehäuse jeweils einen eine oder mehrere Kavitäten aufweisenden, zumeist topfförmigen Gehäuse-Grundkörper mit einer dessen Kavität seitlich begrenzenden, zumeist abschnittsweise kreiszylindrischen Seitenwand, mit einem offenen Ende und mit einem die Kavität auf einer dem offenen Ende gegenüberliegenden und davon entfernten Seite begrenzenden, beispielsweise flachen oder nach außen gewölbten, ggf. auch wieder lösbaren, Rückwand sowie einen mit dem Gehäuse-Grundkörper an dessen offenem Ende, beispielsweise mittels Schraubverbindung, wieder lösbar verbundenen und diesen verschließenden Gehäuse-Deckel. Der zumeist auch ein darin integriertes - beispielsweise das Betrachten eines dahinter innerhalb des Gehäuse-Grundkörpers plazierten Anzeigeelements ermöglichendes - Sichtfenster aufweisende Gehäuse-Deckel ist üblicherweise mit dem Gehäuse-Grundkörper verschraubt, beispielsweise nach Art eines Schraubverschlusses. Nämliches Sichtfenster ist hierbei zumeist mittels einer aus transluzentem bzw. transparentem Material, wie etwa Glas, Glaskeramik oder Kunststoff, bestehenden, zumeist Fensterscheibe gebildet, das eine in einem zumeist metallischen oder zumindest metallisierten *Deckelgrundkörper vorgesehene* (Fenster-)*Öffnung abdeckt. Die Öffnung ist üblicherweise in einem* Deckelboden des *Deckelgrundkörpers eingeformt, während die Fensterscheibe* auf einer der Kavität zugewandten Seite eines Deckelbodens plaziert und daselbst fixiert ist, und zwar derart, daß nämliche Fensterscheibe die Öffnung wieder verschließt.

Industrietaugliche elektronische Geräte, mithin auch deren jeweiliges Elektronik-Gehäuse und deren darin jeweils untergebrachte Gerät-Elektronik, müssen bekanntlich sehr hohen Schutzanforderungen genügen, insb. hinsichtlich der Abschottung der darin plazierten elektrischen Bauteile gegen äußere Umwelteinflüsse, hinsichtlich des Schutzes gegen allfälliges Berühren spannungsführender Bauteile und/oder hinsichtlich des Unterbindens von elektrischen Zündfunken im Fehlerfall. Hierzu gehört beispielsweise auch die Anforderung, daß ein elektrischer Strom, der, beispielsweise bei Körperschluß, via Elektronik-Gehäuse gen Masse oder Erde fließen könnte, einen maximal zulässigen Höchstwert nicht überschreiten darf. Bei einem Anschluß des elektrischen Geräts an 250 V beträgt dieser zulässige Höchstwert beispielsweise 10 mA. Werden diese Anforderungen erfüllt, so entspricht das Gerät zumindest den Anforderungen der Schutzklasse 11, d. h. es handelt sich um ein elektrisches Gerät mit Schutzisolierung. Zur Realisierung dieser Anforderungen ist es demnach erforderlich, daß das Gehäuse des elektrischen Geräts gegenüber allen spannungsführenden Teilen des Geräts ausreichend isoliert ist. Eine solche Isolierung ist insbesondere dann notwendig, wenn es sich um ein Gehäuse aus elektrisch leitfähigem Material, beispielsweise einem Metall, handelt. Darüberhinaus sind Elektronik-Gehäuse, mithin die darin plazierte Gerät-Elektronik, gegen Eindringen von Nässe oder Fremdstoffen/-körper, insb. Staub, sowie vor Berührung von außen in ausreichendem Maße zu schützen. Der seitens des jeweiligen Elektronik-Gehäuse, nicht zuletzt auch den gegeben Anwendungs- und Umgebungsbedingungen entsprechend, zu erfüllende Schutzgrad gegen Eindringen, etwa durch Berührung, Fremdkörper bzw. Wasser, ist beispielsweise anhand der in den Deutschen Normen DIN EN 60529 bzw. DIN 40 050 definierten Schutzarten, z.B. "staubgeschützt bzw. allseitiges Spritzwasser (IP54)" oder "staubdicht bzw. dauerndes Untertauchen (IP68)", bzw. -klassen oder gemäß Industriestandard NEMA 250 bestimmbar.

Elektronische Geräte, mithin auch Feldgeräte, die auch in explosionsgefährdeten Bereichen betrieben werden sollen, müssen darüberhinaus auch sehr hohen Sicherheitsanforderungen hinsichtlich des Explosionsschutzes genügen. Dabei geht es im besonderen darum, die Bildung von Funken sicher zu vermeiden oder zumindest sicherzustellen, daß ein im Inneren eines abgeschlossenen Raumes allfällig entstehender Funke keine Auswirkungen auf die Umgebung hat, um so die eine potentiell mögliche Auslösung einer Explosion sicher zu verhindern. Wie beispielsweise auch in der eingangs genannten US-B 63 66 436 oder der US-B 65 56 447 hierzu ausgeführt, werden im Zusammenhang mit Explosionsschutz verschiedene Zündschutzarten unterschieden, die jeweils auch in einschlägigen, elektrische Betriebsmittel für explosionsgefährdete Bereiche betreffenden Standards und Normen entsprechend manifestiert sind, wie z.B. in den europäischen Normen EN 60079-xx, den US-amerikanischen Normen FM36xx, der kanadischen Norm C22.2, der internationale Norm IEC 60079-18 oder den Normen DIN EN 50 014 ff. So ist z.B. gemäß der Europäischen Norm EN 60079-11:2007 Explosionsschutz gegeben, wenn elektronische Geräte gemäß der darin definierten Zündschutzart oder auch Schutzklasse mit dem Namen "Eigensicherheit" (Ex-i) ausgebildet sind. Gemäß dieser Schutzklasse haben die Werte für die elektrischen Größen Strom, Spannung und Leistung in einem elektronischen Gerät zu jeder Zeit jeweils unterhalb eines vorgegebenen Grenzwertes zu liegen. Die drei Grenzwerte sind so gewählt, daß im Fehlerfall, z.B. durch einen Kurzschluß, die maximal entstehende Wärme nicht ausreicht, um einen Zündfunken zu erzeugen. Der Strom wird z.B. durch Widerstände, die Spannung z.B. durch Zener-Dioden und die Leistung durch entsprechende Kombination von strom- und spannungsbegrenzenden Bauteilen unter den vorgegebenen Grenzwerten gehalten. In der Europäischen Norm EN 60079-7:2007 ist eine weitere Schutzklasse mit dem Namen "Erhöhte Sicherheit" (Ex-e) angegeben. Bei elektronischen Geräten, die gemäß dieser Schutzklasse ausgebildet sind, wird der Zünd- bzw. Explosionsschutz dadurch erzielt, daß die räumlichen Abstände zwischen zwei verschiedenen elektrischen Potentialen so groß sind, daß eine Funkenbildung auch im Fehlerfall aufgrund der Distanz nicht auftreten kann. Dies kann jedoch unter Umständen dazu führen, daß Schaltungsanordnungen sehr große Abmessungen aufweisen müssen, um diesen Anforderungen zu genügen. Als eine andere Schutzklasse ist in der Europäischen Norm EN 60079-1:2007 ferner die Zündschutzart "Druckfeste Kapselung'" (Ex-d) aufgeführt. Elektrische Geräte die gemäß dieser Schutzklasse ausgebildet sind, müssen ein druckfestes Gehäuse aufweisen, durch das sichergestellt ist, daß eine im Inneren des Gehäuses auftretende Explosion nicht in den Außenraum übertragen werden kann. Druckfeste Gehäuse sind, damit sie eine ausreichende mechanische Festigkeit aufweisen, vergleichsweise dickwandig ausgebildet. Eine weitere Norm, nämlich die EN 60079-18:2004, betrifft die Schutzklasse "Vergußkapselung" (Ex-m). Dabei handelt es sich um eine Zündschutzart, bei der Bauteile und/oder Baugruppen des elektronischen Geräts, die eine explosionsfähige Atmosphäre durch Funken oder durch Erwärmung potentiell zünden könnten, in eine zumeist elastomere und/oder geschäumte Einbettmasse aus Kunststoff eingekapselt sind, daß ein Kontakt zur explosionsgefährdeten Atmosphäre weitgehend ausgeschlossen und so eine Entzündung unterbunden werden kann. In den USA, in Kanada, in Japan und anderen Ländern gibt es mit vorgenannten Europäischen Normen vergleichbare Standards, etwa FM3600, FM3610 bzw. C22.2 No. 157 etc..

Desweiteren unterliegen elektronische Geräte der in Rede stehenden Art auch Anforderungen betreffend die elektromagnetische Verträglichkeit (EMV) bzw. müssen entsprechenden Prüfnormen genügen.

Bei Gehäusedeckeln mit darin integriertem Sichtfenster bildet dieses insoweit eine Schwachstelle des gesamten Elektronik-Gehäuses, als eine gegen das Eindringen von Feuchtigkeit bzw. Nässe ausreichend dichte Verbindung zwischen Fensterscheibe und *Deckelgrundkörper* nur mit vergleichsweise hohem Aufwand herzustellen ist, etwa durch Verkleben von Fensterscheibe und *Deckelgrundkörper.* Nämliche Verbindung, wie auch die Fensterscheibe selbst müssen zudem auch die Anforderungen hinsichtlich Schlag-, Bruch- bzw. Explosionsfestigkeit erfüllen wie auch jederzeit die geforderte ausreichende Sperr- bzw. Schirmwirkung gegen elektromagnetische Wellen, mithin die geforderte elektromagnetische Verträglichkeit vorweisen können.

Eine Aufgabe der Erfindung besteht nunmehr darin, einen ein Sichtfenster aufweisenden Gehäuse-Deckel für, insb. druck- bzw. explosionsfeste, Elektronik-Gehäuse der vorgenannten Art bereitzustellen, der zum einen auch bei Schlagbeanspruchung des Sichtfensters bzw. nach Absolvieren eines entsprechenden Schlagtests eine nach wie vor ausreichend hohe Sperrwirkung gegen elektromagnetische Wellen aufweist, und der zum anderen dennoch vergleichsweise einfach, mithin kostengünstig hergestellt werden kann.

Zur Lösung besteht die Erfindung in einem Gehäuse-Deckel für ein Elektronik-Gehäuse, der einen, beispielsweise topfförmigen und/oder metallischen, Deckelgrundkörper mit einem eine Öffnung aufweisenden Deckelboden sowie eine an einen Rand des Deckelbodens anschließende, umlaufende Deckelseitenwand, eine aus transluzentem, insb. transparentem, Material, beispielsweise Glas, Glaskeramik oder Kunststoff, bestehende, auf einer der Deckelseitenwand zugewandten Seite des Deckelbodens in einer dessen Öffnung verschließenden Weise, beispielsweise unter Zwischenlage einer die Öffnung des Deckelbodens nicht überdeckenden Dichtung, plazierte Fensterscheibe, sowie eine auf einer dem Deckelboden abgewandten Seite der Fensterscheibe plazierte, beispielsweise metallische und/oder ringförmige, Kontaktscheibe, etwa zum galvanischen Verbinden von Fensterscheibe und Deckelseitenwand umfaßt. Die Deckelseitenwand weist auf einer der Fensterscheibe zugewandten Innenseite eine, beispielsweise umlaufende, Rille auf, während die Kontaktscheibe einen auf der Fensterscheibe aufliegenden, beispielsweise galvanisch mit der Fensterscheibe verbundenen bzw. die Fensterscheibe unmittelbar berührenden, Kontaktbereich sowie einen äußeren Rand mit einer Vielzahl von darin eingeformten Zähnen, die mit nämlicher Rille in Eingriff sind, aufweist.

Darüberhinaus besteht die Erfindung ferner auch in einem Elektronik-Gehäuse, das einen eine Kavität zur Aufnahme einer Elektronikbaugruppe aufweisenden Gehäuse-Grundkörper mit einem offenen Ende sowie einen Gehäuse-Deckel der vorgenannten Art umfaßt, der mit dem Gehäuse-Grundkörper an dessen offenem Ende, insb. wiederlösbar und/oder in einer die Kavität abdeckenden Weise, verbunden ist.

Nach einer ersten Ausgestaltung des Gehäuse-Deckels der Erfindung ist vorgesehen, daß die Kontaktscheibe relativ zu einem ursprünglichen Ausgangszustand zumindest teilweise, insb. im Bereich ihres äußeren Randes, elastisch verformt ist.

Nach einer zweiten Ausgestaltung des Gehäuse-Deckels der Erfindung ist vorgesehen, daß zumindest einige der Zähne der Kontaktscheibe relativ zu einem jeweiligen ursprünglichen Ausgangszustand elastisch verformt sind.

Nach einer dritten Ausgestaltung des Gehäuse-Deckels der Erfindung ist vorgesehen, daß Fensterscheibe und Deckelboden miteinander adhäsiv verbunden sind.

Nach einer vierten Ausgestaltung des Gehäuse-Deckels der Erfindung ist vorgesehen, daß die Kontaktscheibe die Fensterscheibe, insb. federnd, gegen den Deckelboden gedrückt hält.

Nach einer fünften Ausgestaltung des Gehäuse-Deckels der Erfindung ist vorgesehen, daß zwischen Fensterscheibe und Deckelboden eine, insb. als Dichtungselement und/oder als Kunststoffschicht ausgebildete, Dichtung plaziert ist.

Nach einer sechsten Ausgestaltung des Gehäuse-Deckels der Erfindung ist vorgesehen, daß die Fensterscheibe auf der dem Deckelboden abgewandten Seite zumindest in einem von der Kontaktscheibe, insb. deren Kontaktbereich, berührten, insb. sich über die gesamte dem Deckelboden abgewandte Seite erstreckenden, Bereich metallisiert ist.

Nach einer ersten Ausgestaltung des Elektronik-Gehäuses der Erfindung ist vorgesehen, daß der Gehäuse-Deckel mit dem Gehäuse-Grundkörper mittels Schraubverbindung verbunden ist.

Nach einer zweiten Ausgestaltung des Elektronik-Gehäuses der Erfindung ist vorgesehen, daß der Gehäuse-Grundkörper eine die Kavität umgebenden Seitenwand aufweist. Dies Ausgestaltung der Erfindung weiterbildend ist ferner vorgesehen, daß eine Außenfläche der Seitenwand des Gehäuse-Grundkörpers, insb. in einem sich an das offene Ende anschließenden Randbereich, wenigstens ein Außengewinde aufweist und daß der Gehäuse-Deckel als ein Schraubverschluß mit einem mit dem Außengewinde in Eingriff stehenden Innengewinde ausgebildet ist; ferner kann aber auch eine Innenfläche der Seitenwand des Gehäuse-Grundkörpers, insb. in einem sich an das offene Ende anschließenden Randbereich ein Innengewinde aufweisen und der Gehäuse-Deckel als ein Schraubverschluß mit einem mit dem Innengewinde im Randbereich in Eingriff stehenden Außengewinde ausgebildet sein.

Nach einer dritten Ausgestaltung des Elektronik-Gehäuses der Erfindung ist vorgesehen, daß die Kavität des Gehäuse-Grundkörpers mittels des Gehäuse-Deckels in einer gegen Spritzwasser dichten und/oder explosionsfesten und/oder den Anforderungen gemäß Zündschutzart "Druckfeste Kapselung (Ex-d)" genügende Weise verschlossen ist.

Ein Vorteil der Erfindung besteht darin, daß durch die Verwendung einer außen bezahnten Kontaktscheibe, deren am äußeren Rand eingeformten Zähnen in eine in die Seitenwand des Gehäuse-Deckels eingeformte, beispielsweise eingestochene, Rille eingreifen gelassen sind, auf sehr einfache gleichwohl sehr effektive Weise, nämlich durch Bildung eines Formschlusses, ein auch schlagsichere, nicht zuletzt auch Schläge von außen gegen das Sichtfenster ohne weiteres überstehende, mechanische wie auch galvanische Verbindung zwischen der Fensterscheibe und dem Gehäusedeckel bzw. dessen Seitenwand geschaffen werden kann. Die Kontaktscheibe kann zudem in vorteilhafter Weise hinsichtlich ihrer auf die Fensterscheibe ausgeübte Federkraft so dimensioniert sein, daß sie nach Art einer Sicherungsscheibe zusätzlich noch die Festigkeit des Sichtfensters gegen Schlag von außen gegen die, beispielsweise eingeklebte, Fensterscheibe erhöht.

Im einzelnen gibt es nun eine Vielzahl von Möglichkeiten, die erfindungsgemäßen Geräte sowie erfindungsgemäße Verwendungen solcher Geräte auszugestalten und weiterzubilden. Dazu wird nicht zuletzt auch auf die den unabhängigen Patentansprüchen nachgeordneten Patentansprüche sowie auf die nachfolgende Erläuterung der Erfindung wie auch vorteilhafter Ausgestaltungen derselben anhand von in den Figuren der Zeichnung dargestellten Ausführungsbeispielen verwiesen; gleiche Teile sind in den Figuren im übrigen mit gleichen Bezugszeichen versehen. Falls es der Übersichtlichkeit dienlich ist, wird auf bereits erwähnte Bezugszeichen in nachfolgenden Figuren verzichtet. Im einzelne sind in:
- Fig. 1: eine Seitenansicht eines als Feldgerät, insb. als ein Coriolis-Massendurchfluß-Meßgerät, ausgebildeten elektronischen Geräts mit einem Elektronik-Gehäuse;
- Fig. 2: perspektivisch in teilweise geschnittener Seitenansicht ein für ein Gerät gemäß Fig. 1 geeignetes Elektronik-Gehäuse;
- Fig. 3: perspektivisch in teilweise geschnittener Seitenansicht ein für ein Elektronik-Gehäuse gemäß Fig. 2 geeigneter Gehäusedeckel mit integriertem Sichtfenster; und
- Fig. 4a, 4b: in verschiedenen Seitenansichten eine für die Bildung eines Sichtfensters in einem Gehäusedeckels gemäß Fig. 3 geeignet Kontaktscheibe.

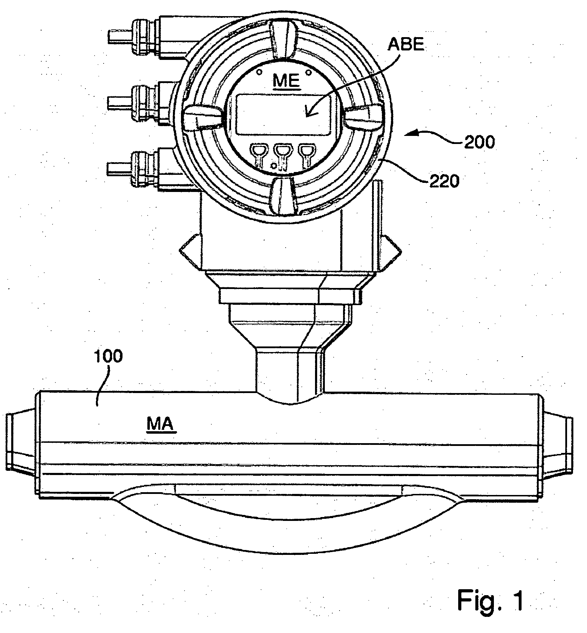

In der Fig. 1 ist ein elektrisches, insb. als Feldgerät, nämlich als Meß- und/oder Schaltgerät der industriellen Meß- und Automatisierungstechnik ausgebildetes, elektronisches Gerät gezeigt.

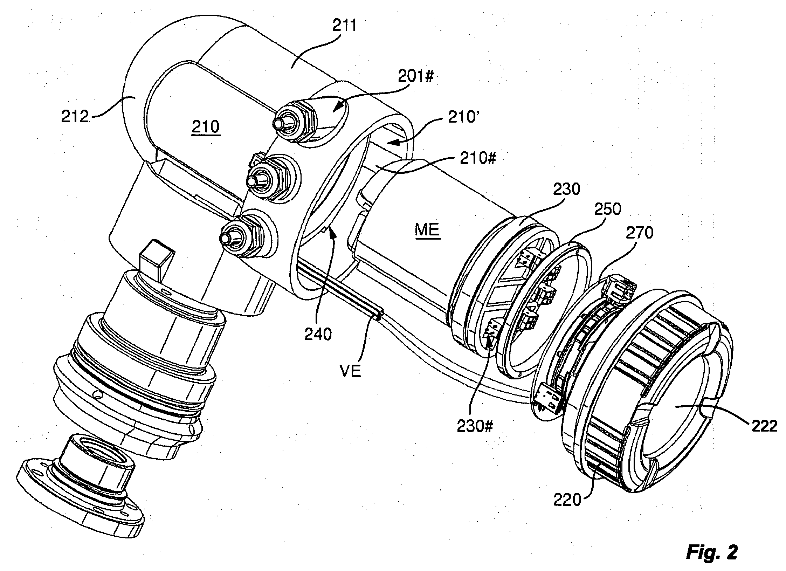

Das Gerät weist ein Elektronik-Gehäuse 200 auf, das - wie auch aus einer Zusammenschau von Fig. 1 und 2 ersichtlich - mittels eines eine Kavität 210# aufweisenden - hier im wesentlichen topfförmigen - Gehäuse-Grundkörpers 210 mit einem offenen Ende 210' und eines mit dem Gehäuse-Grundkörper an dessen offenem Ende 210' wieder lösbar verbundenen und diesen, beispielsweise spritzwasser- oder ggf. auch staubdicht und/oder explosionsfest, verschließenden Gehäuse-Deckel 220 gebildet ist. Der Gehäuse-Deckel 220 weist - wie auch aus einer Zusammenschau von Fig. 1, 2 und 3 ersichtlich - einen - hier ebenfalls topfförmigen - Deckelgrundkörper 221, insb. aus Metall, mit einem Deckelboden 221 + sowie eine an einen Rand des Deckelbodens 221+ anschließende, umlaufende, nämlich eine in sich geschlossene Mantelfläche aufweisende, Deckelseitenwand 221# auf.

Die Kavität 210# dient u.a. dazu elektrische bzw. elektronische Bauteile bzw. damit gebildete, beispielsweise auch in Elektronik-Einsätzen gekapselten und/oder in einen Verguß aus Kunststoff, wie etwa Polyurethan, Silikon, Epoxydharz oder dergleichen, eingebettete, im Ergebnis zu einer entsprechenden Geräte-Elektronik ME zusammengeschalteten Baugruppen des Geräts aufzunehmen, nicht zuletzt auch um selbige gegen Umwelteinflüsse oder Berührung zu schützen. Der Gehäuse-Grundkörper 210 weist eine dessen Kavität 210# seitlich begrenzenden, insb. metallischen und/oder zumindest abschnittsweise kreiszylindrischen, Seitenwand 211, mit einem offenen Ende und mit einem die Kavität auf einer dem offenen Ende gegenüberliegenden und davon entfernten Seite begrenzenden, insb. flachen oder nach außen gewölbten, Rückwand 212 auf. Der Gehäuse-Grundkörper kann beispielsweise ein Monolith sein, bei dem Rück- und Seitenwand fügstellenfrei miteinander verbunden sind; Rück- und Seitenwand des, beispielsweise vollständig aus Aluminium oder vollständig aus Edelstahl gefertigten, Gehäuse-Grundkörpers können beispielsweise aber auch stoffschlüssige miteinander verbunden sein, etwa mittels entsprechender Schweißnaht. Nicht zuletzt im Falle eines monolithischen, nämlich frei von Fügestellen gehaltenen Gehäuse-Grundkörpers kann dieser beispielsweise aus Druckgußmaterial, etwa unter Druck gegossenem Aluminium, oder einem Feingußmaterial, etwa Edelstahl, bestehen.

Im Betrieb ist das elektronische Gerät an eine externe, ggf. auch vom Gerät entfernte elektrische Energieversorgung angeschlossen. Die dafür verwendeten Anschlußleitungen können - wie auch aus der Zusammenschau der Fig. 1 und 2 ersichtlich - beispielsweise von der jeweils anzuschließenden Elektronik-Gehäuses, außerhalb plazierte elektrische Komponente, mithin Komponenten einer Energieversorgung- und/oder eines übergeordneten Datenverarbeitungssystem, via im Randbereich des offenen Endes des Gehäuse-Grundkörpers vorgesehene Durchführungen 201# in die Kavität hereingeführt und an darin entsprechend plazierte, beispielsweise mit einer internen Versorgungsschaltung und/oder einem Modem des Geräts in Verbindung stehenden, Anschlußklemmen elektrisch angeschlossen sein.

Zwecks der gesonderten Unterbringung des, etwa im Zuge eines Software-Updates und/oder einer vor Ort durchgeführten Parametrierung der Gerät-Elektronik gelegentlich herauszunehmenden, beispielsweise auch der Zündschutzart "Eigensicherheit (Ex-i)" genügenden, Anzeige- und Bedieneinheit ABE kann das Elektronik-Gehäuse weiters eine in der Kavität 210# plazierte, diese beispielsweise auch staub- oder spritzwasserdicht abschließende, Trennwand 270 zur Bildung einer sich zwischen einer dem Gehäusedeckel zugewandten ersten Seite nämlicher Trennwand und einer der Kavität des Gehäuse-Grundkörpers zugewandten Innenseite des Gehäusedeckels erstreckenden Gehäuse-Kammer 203 aufweisen. Die, beispielsweise inform einer dünnen Metallplatte ausgeführte, Trennwand 270 kann zudem so ausgebildet sein, daß sie nach Abnehmen des Gehäuse-Deckels vom Gehäuse-Grundkörper 210 via offenes Ende 210' des Gehäuse-Grundkörpers, etwa zwecks Erreichens der dahinter plazierten Geräte-Elektronik ME, wieder herausgenommen werden kann.

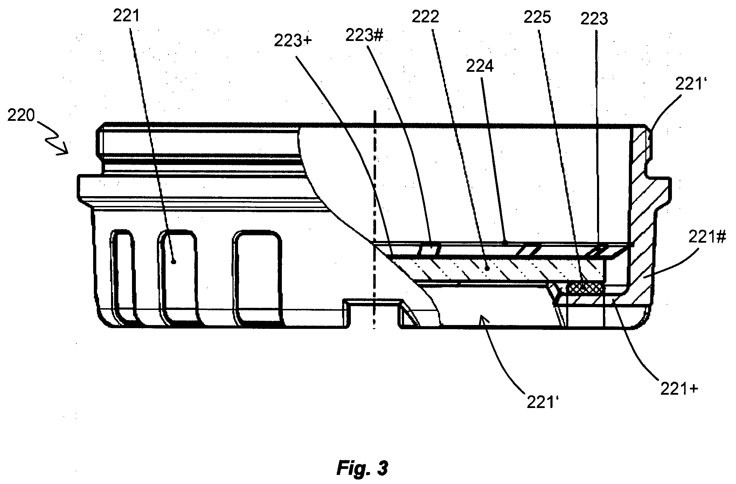

Der - hier ebenfalls einen im wesentlichen kreisförmigen Querschnitt aufweisende - Gehäuse-Deckel 220 ist - wie auch in Fig. 1, 2 bzw. 3 schematisch dargestellt - ferner mit einem Sichtfenster ausgestattet und kann beispielsweise mit dem Gehäuse-Grundkörper 210 mittels Schraubverbindung verbunden sein. Demnach kann der Gehäuse-Deckel 220, wie bei elektronischen Geräten der in Rede stehenden Art durchaus üblich, beispielsweise selbst als ein Schraubdeckel ausgebildet sein. Zum wiederlösbaren Verbinden des Gehäuse-Deckels mit dem Gehäuse-Grundkörper weisen gemäß einer Ausgestaltung der Erfindung eine Außenfläche 211' der Seitenwand 211 des Gehäuse-Grundkörpers, insb. in einem sich an das offene Ende anschließenden Randbereich, wenigstens ein Außengewinde und in entsprechender Weise der Gehäuse-Deckel 220 ein mit nämlichem Außengewinde in Eingriff stehenden Innengewinde auf. Alternativ dazu können die Innenfläche 211" der Seitenwand 211 des Gehäuse-Grundkörpers in Randbereich aber beispielsweise auch ein Innengewinde und der Gehäuse-Deckel 220 - wie auch in Fig. 3 schematisiert dargestellt - ein entsprechendes, nämlich mit dem Innengewinde im Randbereich in Eingriff stehendes Außengewinde 221' aufweisen.

Falls erforderlich können Gehäuse-Deckel 220 und Gehäuse-Grundkörper 210 ferner so ausgebildet, etwa durch Verwendung ausreichend fester Material und entsprechenden Materialstärken, und - nicht zuletzt auch unter Wahrung der für Flammendurchschlag- und Explosionssicherheit erforderlichen Spaltmaße - so miteinander verbunden sein, daß der Gehäuse-Grundkörper 210 mittels des Gehäuse-Deckels 220 schlußendlich in einer den Anforderungen gemäß Zündschutzart "Druckfeste Kapselung (Ex-d)" genügende Weise verschlossen werden kann bzw. daß das Elektronik-Gehäuse 200 einem darin allfällig auftretenden Explosionsdruck von mehr als 20 bar, insb. mehr als 60 bar, zerstörungsfrei standhält.

Das elektronische Gerät ist im besonderen ferner dafür vorgesehen, zum Messen einer physikalischen und/oder chemischen Meßgröße eines in einer, beispielsweise sich zumindest abschnittsweise durch eine explosionsgefährdete Gefahrenzone erstreckenden, Rohrleitung und/oder in einem, beispielsweise innerhalb einer explosionsgefährdeten Gefahrenzone plazierten, Behälter geführten Mediums verwendet zu werden. Dementsprechend kann es sich bei dem elektrischen Gerät beispielsweise um ein magnetisch-induktives Durchflußmeßgerät, ein Wirbel-Durchflußmeßgerät, ein Ultraschall-Durchflußmeßgerät, ein thermisches Massendurchfluß-Meßgerät, ein Druck-Meßgerät, ein Füllstand-Meßgerät, ein Temperatur-Meßgerät, ein ph-Wert-Meßgerät, ein Leitfähigkeit-Meßgerät oder - wie in den Fig. 1 lediglich beispielhaft und schematisiert dargestellt - ein Coriolis-Massendurchfluß-Meßgerät handeln. Das elektronische Gerät umfaßt nach einer Weiterbildung der Erfindung dementsprechend wenigstens einen mit in Elektronik-Gehäuse plazierten elektronischen Bauteilen bzw. wenigstens einer damit gebildeten elektronischen Baugruppe mittels, beispielsweise abschnittsweise flexibler, Verbindungsleitung elektrisch gekoppelter, insb. galvanisch verbundenen, Meßaufnehmer MA, der im Betrieb zumindest zeitweise wenigstens ein mit einer physikalischen und/oder chemischen Meßgröße des jeweils zu messenden, insb. in einer Rohrleitung und/oder in einem Behälter geführten, Mediums korrespondierendes Meßsignal via Verbindungsleitung bereitstellt, etwa für eine mittels im Elektronik-Gehäuse plazierten elektronischen Bauteilen gebildeten elektronische Meß- und Auswerteschaltung, beispielsweise inform eines Mikrocomputers. Als Meßaufnehmer MA kann beispielsweise ein in Massendurchfluß- bzw. Dichte-Meßgeräten häufig verwendeter Meßaufnehmer vom Vibrationstyp mit zwei parallelen gebogenen Meßrohren dienen, die im Betrieb zwecks Erzeugung des wenigstens einen Meßsignals mittels eines darauf einwirkenden elektro-mechanischen Schwingungserregers aktiv zu mechanischen Schwingungen angeregt sind. Zum Visualisieren von Gerät intern erzeugten Meßwerten, beispielsweise also Massendurchflußmeßwerten, Dichtemeßwerten, Viskositätsmeßwerten oder Volumendurchflußmeßwerten etc., und/oder gegebenenfalls Gerät intern generierten Statusmeldungen, wie etwa einer das Gerät betreffenden Fehlermeldung oder einen das Medium oder den zu überwachenden Prozeß betreffende Alarm, vor Ort umfaßt das Gerät nach Weiterbildung der Erfindung desweiteren ein zumindest zeitweise mit der Gerät-Elektronik kommunizierendes Anzeige- und Bedieneinheit ABE, etwa mit einem im Elektronik-Gehäuse unmittelbar hinter einem im Gehäuse-Deckel vorgesehenen Sichtfenster plazierten LCD- oder TFT-Display und/oder mit integriertem nicht-flüchtigen Datenspeicher für Meß- und/oder für Konfigurationsdaten.

Zwecks Bildung des Sichtfensters ist im Deckelboden 221 + des Gehäusegrundkörpers 221 -wie aus einer Zusammenschau der Fig. 1, 2 und 3 ohne weiters ersichtlich - eine Öffnung 221' vorgesehen, die mittels einer auf einer der Deckelseitenwand 221# zugewandten Seite des Deckelbodens 221+ plazierte Fensterscheibe 222 aus transluzentem, insb. transparentem, Material, wie etwa einem Glas, einer Glaskeramik oder einem Kunststoff, verschlossen ist. Zum Abdichten des Sichtfensters, etwa gegen Feuchtigkeit bzw. von außen auftreffendes Spritzwasser, ist gemäß einer weiteren Ausgestaltung der Erfindung zwischen Deckelboden 221+ und Fensterscheibe 222 eine die Öffnung 221' des Deckelbodens nicht überdeckende Dichtung 225 gelegt, beispielsweise inform eines Flachrings, eines O-Rings oder eines anderen vorgefertigten ringförmigen, ggf. auch standardisierten, Dichtungselements. Die Dichtung 225 kann beispielsweise aber auch mittels einer, insb. ringförmig gelegten, Schicht aus - beispielsweise auch adhäsiv gegen Fensterscheibe und/oder Deckelboden wirkendem - Kunststoff, wie etwa einem Elastomere, gebildet sein. Auf einer dem Deckelboden 221+ abgewandten Seite der Fensterscheibe 222 ist ferner eine, insb. ringförmige, Kontaktscheibe 223 plaziert, die einen auf der Fensterscheibe 222 aufliegenden, insb. die die Fensterscheibe unmittelbar berührenden, mithin galvanisch mit der Fensterscheibe verbundenen, Kontaktbereich 223+ sowie einen äußeren Rand 223' mit einer Vielzahl von darin eingeformten Zähnen 223# aufweist. Auch die Kontaktscheibe 223 ist hierbei selbstverständlich so geformt, nicht zuletzt auch hinsichtlich eines inneren lichten Durchmessers d1 so dimensioniert, und so im Gehäusedeckel plaziert, daß die Öffnung nämliche Kontaktscheibe 223 nicht verdeckt ist, mithin die Sicht durch die Öffnung hindurch ermöglicht ist. Ein äußere Durchmesser d2 der Kontaktscheibe 223 ist ferner so gewählt, daß diese bei der Montage des Sichtfensters bequem in den Deckelgrundkörper eingelegt werden kann, im übrigen aber den Kontaktbereich der Kontaktscheibe 223 möglichst groß beläßt.

Die Zähne 223# der Kontaktscheibe 223 kontaktieren die Deckelseitenwand 221# auf deren Innenseite, wodurch die Kontaktscheibe im Gehäusedeckelgrundkörper 221 gehalten ist. Nach einer weiteren Ausgestaltung der Erfindung ist hierbei vorgesehen, daß die Kontaktscheibe 223 relativ zu einem ursprünglichen Ausgangszustand zumindest teilweise, nicht zuletzt auch im Bereich ihres äußeren Randes 223', elastisch verformt ist; dies im besonderen auch derart, daß zumindest einige der Zähne 223# der Kontaktscheibe 223 relativ zu einem jeweiligen ursprünglichen Ausgangszustand elastisch verformt sind.

Die Kontaktscheibe 223 dient bei der vorliegenden Erfindung im besonderen dem galvanischen Verbinden von Fensterscheibe 222 und Deckelseitenwand 221#, mithin dem galvanischen Verbinden von Fensterscheibe 222 und Deckelgrundkörper 221. Die Fensterscheibe 222 ist nämlich gemäß einer weiteren Ausgestaltung der Erfindung, nicht zuletzt auch zur Bildung eines elektromagnetisch Wellen überwiegend reflektierenden Schirms, auf der dem Deckelboden 221+ abgewandten Seite zumindest in einem von der - hierfür ebenfalls metallischen bzw. metallisierten - Kontaktscheibe 223, nicht zuletzt auch deren Kontaktbereich, berührten Bereich metallisiert. Nämlicher, beispielsweise mittels physikalischer Gasphasenabscheidung (PVD) hergestellte, metallisierte Bereich der Fensterscheibe 222 kann sich hierbei auch über die gesamte dem Deckelboden 221+ abgewandte Seite der Fensterscheibe 222 erstrecken. Ferner kann die Kontaktscheibe 223 aber auch als ein die Fensterscheibe 222 gegen den Deckelboden 221+ gedrückt haltendes Federelement dienen, derart, daß die Kontaktscheibe 223 die, ggf. auch bereits mit dem Deckelboden 221+ verklebte, Fensterscheibe 222 federnd, nämlich durch Eintrag einer Federkraft, gegen den Deckelboden 221+ gedrückt hält.

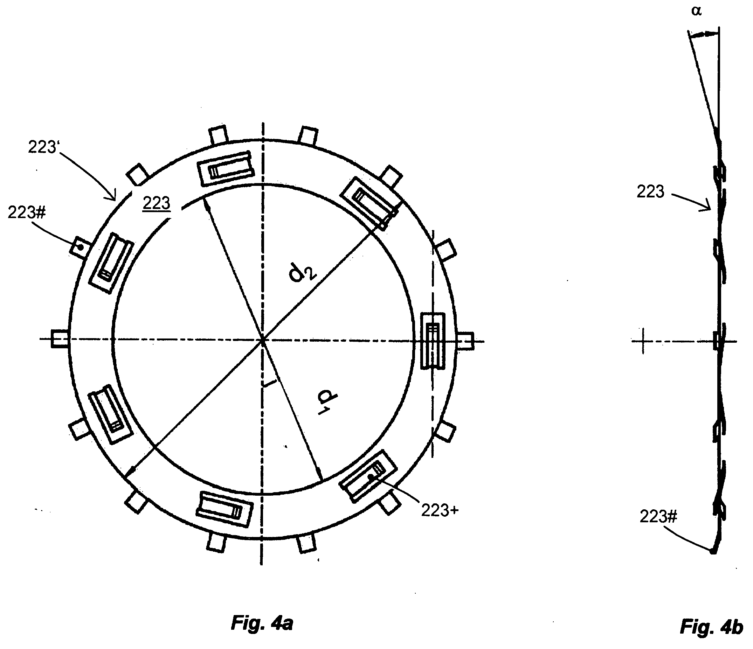

Zwecks einer Erhöhung einer dem Wiederherauslösen der Kontaktscheibe 223 aus dem Deckelgrundkörper 221 entgegenwirkenden Haltekraft - nicht zuletzt auch zwecks Vermeidung eines unerwünschten Herauslösens der Kontaktscheibe 223 aus dem Deckelgrundkörper 221, etwa durch einen Schlag von außen auf die Fensterscheibe 222 - weist die die Deckelseitenwand 221#, wie auch in Fig. 3 schematisch angedeutete, auf ihrer der Fensterscheibe 222 zugewandten Innenseite eine, beispielsweise umlaufende, Rille 224 auf, mit der die Zähne 223# der Kontaktscheibe 223 - praktisch unter Bildung eines Formschlusses - in Eingriff sind. Zur weiteren Erhöhung der vorgenannte Haltekraft einerseits und zum Ermöglichen eines einfachen Einbaus der Kontaktscheibe 223 in den Deckelgrundkörper 221 anderseits sind die Zähne 223# der Kontaktscheibe 223 gemäß einer weiteren Ausgestaltung der Erfindung, wie aus der Fig. 4b ohne weiteres ersichtlich, auch schon im ursprünglichen Ausgangszustand der Kontaktscheibe um einen Winkel α aus einer gedachten, mit dem Kontaktbereich 223# im wesentlichen fluchtenden Horizontalebene der Kontaktscheibe 223 herausgebogen, insb. derart, daß eine gedachte Einhüllende der Kontaktscheibe bereits im ursprünglichen Ausgangszustand der Kontaktscheibe im wesentlichen einer Silhouette eines Konus entspricht. Wie aus einer Zusammenschau der Fig. 4b und 3 ohne weiteres ersichtlich, sind die Zähne 223# im finalen Einbauzustand nämlich ebenfalls um Winkel aus der gedachten Horizontalebene ausgebogen, der allerdings, nicht zuletzt zwecks Erzielung der oben erwähnten Haltekraft bzw. Federwirkung, im Vergleich zum Winkel α im ursprünglichen Ausgangszustand noch größer ausfällt.

## Patentansprüche

1. Gehäuse-Deckel (220) für ein Elektronik-Gehäuse (200), der umfaßt:
- einen, insb. topfförmigen und/oder metallischen, Deckelgrundkörper (221) mit einem eine Öffnung (221') aufweisenden Deckelboden (221+) sowie eine an einen Rand des Deckelbodens anschließende, umlaufende Deckelseitenwand (221#);
- eine aus transluzentem, insb. transparentem, Material bestehende, auf einer der Deckelseitenwand (221#) zugewandten Seite des Deckelbodens (221+) in einer dessen Öffnung (221') verschließenden Weise plazierte Fensterscheibe (222); sowie
- eine auf einer dem Deckelboden abgewandten Seite der Fensterscheibe (222) plazierte, insb. metallische und/oder ringförmige, Kontaktscheibe (223), insb. zum galvanischen Verbinden von Fensterscheibe und Deckelseitenwand,
- wobei die Deckelseitenwand (221#) auf einer der Fensterscheibe (222) zugewandten Innenseite eine, insb. umlaufende, Rille (224) aufweist, und
- wobei die Kontaktscheibe (223)
-- einen auf der Fensterscheibe (222) aufliegenden, insb. galvanisch mit der Fensterscheibe verbundenen bzw. die Fensterscheibe unmittelbar berührenden, Kontaktbereich (223+) sowie
-- einen äußeren Rand (223') mit einer Vielzahl von darin eingeformten Zähnen (223#), die mit der Rille (224) in Eingriff sind, aufweist.

2. Gehäuse-Deckel nach dem vorherigen Anspruch, wobei die Kontaktscheibe relativ zu einem ursprünglichen Ausgangszustand zumindest teilweise, insb. im Bereich ihres äußeren Randes, elastisch verformt ist.

3. Gehäuse-Deckel nach einem der vorherigen Ansprüche, wobei zumindest einige der Zähne der Kontaktscheibe relativ zu einem jeweiligen ursprünglichen Ausgangszustand elastisch verformt sind.

4. Gehäuse-Deckel nach einem der vorherigen Ansprüche,
- wobei Fensterscheibe und Deckelboden miteinander adhäsiv verbunden sind; und/oder
- wobei die Kontaktscheibe die Fensterscheibe, insb. federnd, gegen den Deckelboden gedrückt hält; und/oder
- wobei die Fensterscheibe (222) aus Glas, Glaskeramik oder Kunststoff besteht; und/oder
- wobei die Fensterscheibe (222) auf der der Deckelseitenwand (221#) zugewandten Seite des Deckelbodens (221+) unter Zwischenlage einer die Öffnung des Deckelbodens nicht überdeckenden Dichtung (225) plaziert ist.

5. Gehäuse-Deckel nach einem der vorherigen Ansprüche, wobei zwischen Fensterscheibe und Deckelboden eine, insb. als Dichtungselement und/oder als Kunststoffschicht ausgebildete, Dichtung (225) plaziert ist.

6. Gehäuse-Deckel nach einem der vorherigen Ansprüche, wobei die Fensterscheibe auf der dem Deckelboden abgewandten Seite zumindest in einem von der Kontaktscheibe, insb. deren Kontaktbereich, berührten, insb. sich über die gesamte dem Deckelboden abgewandte Seite erstreckenden, Bereich metallisiert ist.

7. Elektronik-Gehäuse, umfassend:
- einen eine Kavität (210#) zur Aufnahme einer Elektronikbaugruppe aufweisenden Gehäuse-Grundkörper (210) mit einem offenen Ende; sowie
- einen Gehäuse-Deckel (220) gemäß einem der vorherigen Ansprüche, welcher Gehäuse-Deckel (220) mit dem Gehäuse-Grundkörper (210) an dessen offenem Ende, insb. wiederlösbar und/oder in einer die Kavität abdeckenden Weise, verbunden ist.

8. Elektronik-Gehäuse nach Anspruch 7, wobei der Gehäuse-Deckel (220) mit dem Gehäuse-Grundkörper (210) mittels Schraubverbindung verbunden ist.

9. Elektronik-Gehäuse nach Anspruch 7 oder 8, wobei der Gehäuse-Grundkörper eine die Kavität umgebenden Seitenwand (211) aufweist.

10. Elektronik-Gehäuse nach Anspruch 9,
- wobei eine Außenfläche (211') der Seitenwand des Gehäuse-Grundkörpers, insb. in einem sich an das offene Ende anschließenden Randbereich, wenigstens ein Außengewinde aufweist und
- wobei der Gehäuse-Deckel als ein Schraubverschluß mit einem mit dem Außengewinde in Eingriff stehenden Innengewinde ausgebildet ist.

11. Elektronik-Gehäuse nach Anspruch 9,
- wobei eine Innenfläche (211") der Seitenwand des Gehäuse-Grundkörpers, insb. in einem sich an das offene Ende anschließenden Randbereich ein Innengewinde aufweist und
- wobei der Gehäuse-Deckel als ein Schraubverschluß mit einem mit dem Innengewinde im Randbereich in Eingriff stehenden Außengewinde ausgebildet ist.

12. Elektronik-Gehäuse nach einem der Ansprüche 7 bis 11, wobei die Kavität (210#) des Gehäuse-Grundkörpers mittels des Gehäuse-Deckels (220) in einer gegen Spritzwasser dichten und/oder explosionsfesten und/oder den Anforderungen gemäß Zündschutzart "Druckfeste Kapselung (Ex-d)" genügende Weise verschlossen ist.

## Claims

1. Housing cover (220) for an electronics housing (200), comprising:
- a cover base body (221), particularly pot-shaped and/or metallic, with a cover floor (221+) featuring an opening (221'), as well as a circumferential cover side panel (221#), adjacent to an edge of the cover floor;
- a window pane (222) made from translucent, particularly transparent, material located on the side of the cover floor (221 +) facing toward the cover side panel (221#) in such a way that it seals the floor opening (221'), as well as
- a contact disc (223), particularly metallic and/or annular, located on a side of the window pane (222) facing away from the cover floor, particularly for the galvanic connection of the window pane and the cover side panel,
- wherein the cover side panel (221 #) has a groove (224), particularly a circumferential groove, on an inner side facing towards the window pane (222), and
- wherein the contact disc (223)
-- has a contact area (223+) supported on the window pane (222), particularly galvanically connected to the window pane or directly in contact with the window pane, as well as
-- an outer edge (223') with a multitude of teeth (223#) formed in the edge which mesh with the groove (224).

2. Housing cover as claimed in the previous claim, wherein the contact disc is elastically deformed at least partially relative to an original initial state, particularly in the area of its outer edge.

3. Housing cover as claimed in one of the previous claims, wherein at least some of the teeth of the contact disc are elastically deformed relative to an original initial state.

4. Housing cover as claimed in one of the previous claims,
- wherein the window pane and the cover floor are adhesively connected together; and/or
- wherein the contact disc keeps the window pane pressed against the cover floor, particularly in an elastic manner; and/or
- wherein the window pane (222) is made from glass, glass ceramic or plastic; and/or
- wherein the window pane (222) is placed on the side of the cover floor (221 +) facing towards the cover side panel (221 #), with an interposed seal (225) that does not cover the opening of the cover floor.

5. Housing cover as claimed in one of the previous claims, wherein a seal (225) is placed between the window pane and the cover floor, particularly a seal designed as a sealing element and/or as a plastic layer.

6. Housing cover as claimed in one of the previous claims, wherein the window pane on the side facing away from the cover floor is metal at least in an area in contact with the contact disc, particularly its contact area, particularly extending over the entire side facing away from the cover floor.

7. Electronics housing, comprising:
- a housing base body (210) with an open end, said base body having a cavity (210#) designed to hold an electronics assembly, as well as
- a housing cover (220) as claimed in one of the previous claims, said housing cover (220) being connected to the housing base body (210) at its open end, particularly in a detachable manner and/or in a manner that covers the cavity.

8. Electronics housing as claimed in Claim 7, wherein the housing cover (220) is connected to the housing base body (210) via a screw connection.

9. Electronics housing as claimed in Claim 7 or 8, wherein the housing base body has a side panel (211) that surrounds the cavity.

10. Electronics housing as claimed in Claim 9,
- wherein an outer surface (211') of the side panel of the housing base body, particularly in a peripheral area adjacent to the open end, has at least one outer thread, and
- wherein the housing cover is designed as a screw plug with an inner thread that engages with the outer thread.

11. Electronics housing as claimed in Claim 9,
- wherein an inner surface (211 ") of the side panel of the housing base body, particularly in a peripheral area adjacent to the open end, has an inner thread, and
- wherein the housing cover is designed as a screw plug with an outer thread that engages with the inner thread in the peripheral area.

12. Electronics housing as claimed in one of the Claims 7 to 11, wherein the cavity (210#) of the housing base body is sealed by the housing cover (220) in a manner that is sealed tight against spray water and/or in an explosion-proof manner and/or in a manner that meets the requirements of "flameproof enclosure (Ex-d)" explosion protection.

## Revendications

1. Couvercle de boîtier (220) pour un boîtier électronique (200), comprenant :
- un corps de base de couvercle (221), notamment en forme de pot et/ou métallique, avec un fond de couvercle (221+) présentant une ouverture (221'), ainsi qu'une paroi latérale de couvercle (221#) périphérique, jouxtant un bord du couvercle de boîtier ;
- une vitre (222) constituée d'un matériau translucide, notamment transparent, placée sur un côté du fond de couvercle (221 +) faisant face à la paroi latérale de couvercle (221 #), de telle sorte à obturer l'ouverture (221') du fond de couvercle, ainsi que
- un disque de contact (223), notamment métallique et/ou annulaire, placé sur le côté de la vitre (222) situé à l'opposé du fond de couvercle, notamment pour la liaison galvanique entre la vitre et la paroi latérale de couvercle,
- pour lequel la paroi latérale de couvercle (221#) comporte une rainure (224), notamment périphérique, sur son côté intérieur faisant face à la vitre (222), et
- pour lequel le disque de contact (223)
-- présente une zone de contact (223+) reposant sur la vitre (222), notamment reliée par une liaison galvanique avec la vitre ou entrant directement en contact avec la vitre, ainsi que
-- un bord extérieur (223') avec un grand nombre de dents (223#) qui y sont formées, lesquelles sont en prise avec la rainure (224).

2. Couvercle de boîtier selon la revendication précédente, pour lequel le disque de contact est déformé de façon élastique au moins partiellement par rapport à un état d'origine, notamment dans la zone du bord extérieur.

3. Couvercle de boîtier selon l'une des revendications précédentes, pour lequel au moins quelques unes des dents du disque de contact sont déformées de façon élastique par rapport à un état d'origine.

4. Couvercle de boîtier selon l'une des revendications précédentes,
- pour lequel la vitre et le fond de couvercle sont reliés entre eux par une liaison adhésive ; et/ou
- pour lequel le disque de contact maintient pressé la vitre, notamment de façon élastique, contre le fond de couvercle ; et/ou
- pour lequel la vitre (222) est en verre, en vitrocéramique ou en matière plastique ; et/ou
- pour lequel la vitre (222) est placée sur le côté du fond de couvercle (221 +) faisant face à la paroi latérale de couvercle (221 #), avec interposition d'un joint (225) ne recouvrant pas l'ouverture du fond de couvercle.

5. Couvercle de boîtier selon l'une des revendications précédentes, pour lequel est placé, entre la vitre et le fond de couvercle, un joint (225) conçu notamment en tant qu'élément d'étanchéité et/ou en tant que couche de matière plastique.

6. Couvercle de boîtier selon l'une des revendications précédentes, pour lequel la vitre est métallisée sur le côté opposé au fond de couvercle, au moins dans une zone en contact avec le disque de contact, notamment dans sa zone de contact, notamment s'étendant sur la totalité du côté situé à l'opposé du fond de couvercle.

7. Boîtier électronique, comprenant :
- un corps de base de boîtier (210) avec une extrémité ouverte, lequel corps comporte une cavité (210#) destinée à la réception d'un module électronique, ainsi que
- un couvercle de boîtier (220) selon l'une des revendications précédentes, lequel couvercle de boîtier (220) est relié avec le corps de base de boîtier (210) en son extrémité ouverte, notamment de manière amovible et/ou de telle sorte à recouvrir la cavité.

8. Boîtier électronique selon la revendication 7, pour lequel le couvercle de boîtier (220) est relié avec le corps de base de boîtier (210) au moyen d'un assemblage vissé.

9. Boîtier électronique selon la revendication 7 ou 8, pour lequel le corps de base de boîtier (210) comporte une paroi latérale (211) entourant la cavité.

10. Boîtier électronique selon la revendication 9,
- pour lequel une surface extérieure (211') de la paroi latérale du corps de base de boîtier comporte, notamment dans une zone marginale jouxtant l'extrémité ouverte, au moins un filetage extérieur, et
- pour lequel le couvercle de boîtier est conçu en tant que fermeture à vis avec un filetage intérieur en prise avec le filetage extérieur.

11. Boîtier électronique selon la revendication 9,
- pour lequel une surface intérieure (211 ") de la paroi latérale du corps de base de boîtier comporte, notamment dans une zone marginale jouxtant l'extrémité ouverte, au moins un filetage intérieur, et
- pour lequel le couvercle de boîtier est conçu en tant que fermeture à vis avec un filetage extérieur en prise, dans la zone marginale, avec le filetage intérieur.

12. Boîtier électronique selon l'une des revendications 7 à 11, pour lequel la cavité (210#) du corps de base de boîtier est fermée au moyen du couvercle de boîtier (220) d'une manière suffisamment étanche contre les projections d'eau et/ou résistante aux explosions et/ou conformément aux exigences selon le mode de protection "Enveloppe antidéflagrante (Ex-d)".
